# EUROPEAN PATENT SPECIFICATION

(11) **EP 4 184 469 B1**
(45) Date of publication and mention of the grant of the patent: **28.01.2026**
(21) Application number: 22207604.4
(22) Date of filing: 15.11.2022
(51) Int. Cl.: G08B 29/18, G08B 17/00

(54) **AUTOMATIC CONFIGURATION OF FIRE SYSTEM**
AUTOMATISCHE KONFIGURATION FÜR BRANDSCHUTZSYSTEM
CONFIGURATION AUTOMATIQUE DE SYSTEME DE DETECTION D'INCENDIE

(30) Priority: 17.11.2021 US 202163280306 P
(43) Date of publication of application: 24.05.2023
(73) Proprietor: Carrier Corporation, Palm Beach Gardens, FL 33418 (US)
(72) Inventor: SUBRAMANIAN, Sabarigirinathan, 500081 Hyderabad (IN); KOTHAKOTA, Pratibha, 500081 Hyderabad (IN); PANTAPALLI, Dhana Shekhar, 500081 Hyderabad (IN); SOMISETTY, Ranjith Kumar, 500081 Hyderabad (IN)
(74) Representative: Dehns

(56) References cited:
- EP-A1- 3 770 793
- WO-A1-2020/055646
- WO-A1-2021/044216
- WO-A2-2020/123417

## Description

The subject matter disclosed herein generally relates to the field of fire detection systems, and more specifically, an apparatus and method for designing fire detection systems.

Conventional building fire detections systems consist of distributed components that must be designed, identified, installed, and commissioned in accordance with requirements and regulations. The design process is also a major determinant of the total system cost.

WO 2021/044216 A1 discloses systems and methods for modeling and simulation for architectural planning, including selecting equipment through automatic simulations.

WO 2020/123417 A2 discloses a method of commissioning or maintenance of an alarm system.

WO 2020/055646 A1 discloses a method of determining a probability of a fire within one or more rooms of a building.

EP 3770793 A1 discloses a system and method for designing a layout for a smoke detection system.

According to one aspect of the invention, a computer implemented method of designing a fire detection system is provided. The computer implemented method includes determining a fire detection device placement scheme for one or more fire detection devices within a building based on inputs received from a user and a fire detection device database; determining an alert device placement scheme for one or more alert devices within the building based on the inputs received from the user and an alert device database; determining one or more fire detector loop wires to connect the one or more fire detection devices to a fire panel in a fire detection loop; determining one or more alert loop wires to connect the one or more alert devices to the fire panel in an alert loop; and generating a map that displays a location of each of the one or more fire detection devices, the one or more alert devices, the one or more fire detector loop wires, and the one or more alert loop wires within the building. The method includes determining an autoconfiguration of the fire panel to associate a specific alert device of the one or more alert devices with a specific fire detection device of the one or more fire detection devices.

The method may include displaying the map on a computing device.

The method may include: activating the specific fire detection device; detecting whether the specific alert device activates in response to the specific fire detection device being activated; and determine whether the autoconfiguration was successful based on detecting whether the specific alert device activates in response to the specific fire detection device being activated.

The method may include that the fire detection device placement scheme includes a number of the one or more fire detection devices.

The method may include that the alert device placement scheme includes a number of the one or more alert devices.

The method may include that the fire detection device placement scheme includes a type of the one or more fire detection devices.

The method may include that the alert device placement scheme includes a type of the one or more alert devices.

The method may include determining a length of the fire detection loop and a length of the one or more detector loop wires within the fire detection loop.

The method may include determining a length of the alert loop and a length of the one or more alert wires within the alert loop.

According to another aspect of the invention, a system for designing a fire detection system is provided. The system includes: a processor; and a memory including computer-executable instructions that, when executed by the processor, cause the processor to perform operations. The operations include: determining a fire detection device placement scheme for one or more fire detection devices within a building based on inputs received from a user and a fire detection device database; determining an alert device placement scheme for one or more alert devices within the building based on the inputs received from the user and an alert device database; determining one or more fire detector loop wires to connect the one or more fire detection devices to a fire panel in a fire detection loop; determining one or more alert loop wires to connect the one or more alert devices to the fire panel in an alert loop; and generating a map that displays a location of each of the one or more fire detection devices, the one or more alert devices, the one or more fire detector loop wires, and the one or more alert loop wires within the building. The operations include determining an autoconfiguration of the fire panel to associate a specific alert device of the one or more alert devices with a specific fire detection device of the one or more fire detection devices.

The operations may further include displaying the map on a computing device.

The operations may further include: activating the specific fire detection device; detecting whether the specific alert device activates in response to the specific fire detection device being activated; and determine whether the autoconfiguration was successful based on detecting whether the specific alert device activates in response to the specific fire detection device being activated.

The fire detection device placement scheme may include a number of the one or more fire detection devices.

The alert device placement scheme may include a number of the one or more alert devices.

The fire detection device placement scheme may include a type of the one or more fire detection devices.

The alert device placement scheme may include a type of the one or more alert devices.

The operations may further include: determining a length of the fire detection loop and a length of the one or more detector loop wires within the fire detection loop.

According to another aspect of the invention, a computer program product tangibly embodied on a non-transitory computer readable medium is provided. The computer program product includes instructions that, when executed by a processor, cause the processor to perform operations including: determining a fire detection device placement scheme for one or more fire detection devices within a building based on inputs received from a user and a fire detection device database; determining an alert device placement scheme for one or more alert devices within the building based on the inputs received from the user and an alert device database; determining one or more fire detector loop wires to connect the one or more fire detection devices to a fire panel in a fire detection loop; determining one or more alert loop wires to connect the one or more alert devices to the fire panel in an alert loop; generating a map that displays a location of each of the one or more fire detection devices, the one or more alert devices, the one or more fire detector loop wires, and the one or more alert loop wires within the building; and determining an autoconfiguration of the fire panel to associate a specific alert device of the one or more alert devices with a specific fire detection device of the one or more fire detection devices.

The method described above may be implemented on any of the systems described above and/or implemented by the computer program product described above.

Technical effects of embodiments of the present invention include automatically designing a fire detection system and configuring the fire detection system based on building maps and known constraints.

The foregoing features and elements may be combined in various combinations without exclusivity, unless expressly indicated otherwise. These features and elements as well as the operation thereof will become more apparent in light of the following description and the accompanying drawings. It should be understood, however, that the following description and drawings are intended to be illustrative and explanatory in nature and non-limiting.

Certain embodiments will now be described in greater detail, by way of example only, and with reference to the accompanying drawing in which:
FIG. 1 is a schematic illustration of a system for designing a fire detection system; and
FIG. 2 is a flow diagram illustrating a computer implemented method of designing a fire detection system.

A detailed description of one or more embodiments of the disclosed apparatus and method are presented herein by way of exemplification and not limitation with reference to the Figures.

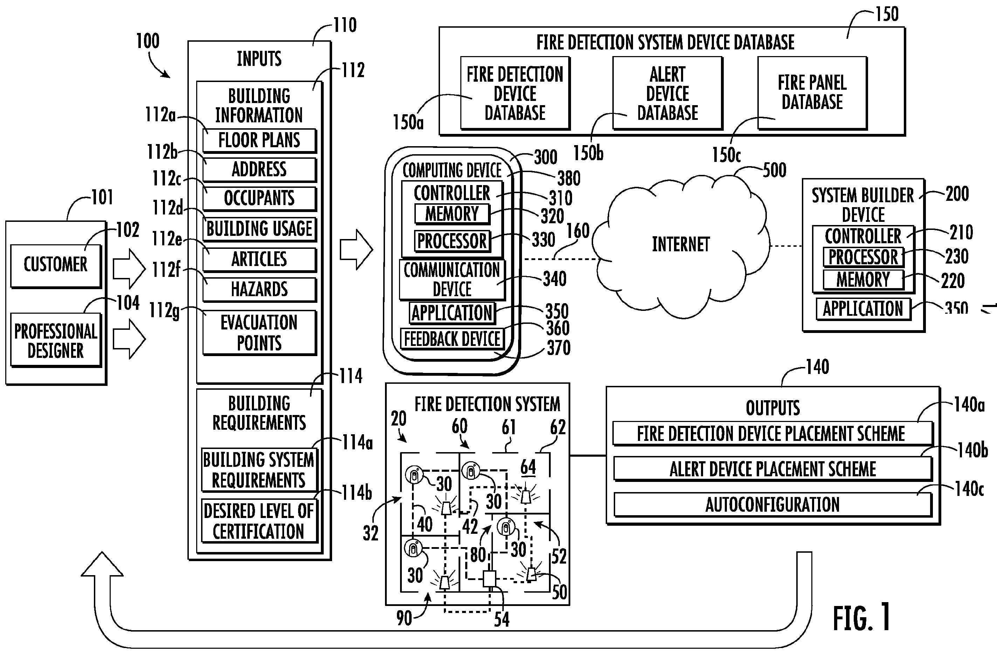

Referring now to FIG. 1, a schematic view of a system 100 for designing a fire detection system 20 is illustrated in accordance with an embodiment of the present invention. It should be appreciated that, although particular systems are separately defined in the schematic block diagrams, each or any of the systems may be otherwise combined or separated via hardware and/or software. In an embodiment, the system 100 for designing a fire detection system 20 may be a web-based system. In an embodiment, the system 100 may be used by a user 101 to design a fire detection system 20 that may be for residential homes/buildings or commercial buildings. For example, the system 100 may be for a user 101 to design a fire detection for their home via a tablet or any other computer device. The user 101 may be a do-it-yourself (DIY) customer 102 or a professional designer 104.

The customer 102 or professional designer 104 may utilize a computing device 300 to provide inputs 110 into a fire detection system design application 350 that may be installed on the computing device 300 and/or a system builder device 200 connected to the computing device 300 through the internet 500. For example, the software code of the fire detection system design application 350 may be installed completely on the computing device 300 or partly on the mobile device and partly on the system builder device 200, such as, for example, a software-as-a-service.

The system builder device 200 includes a controller 210 configured to control operations of the system builder device 200. The controller 210 may be an electronic controller including a processor 230 and an associated memory 220 comprising computer-executable instructions (i.e., computer program product) that, when executed by the processor 230, cause the processor 230 to perform various operations. The processor 230 may be, but is not limited to, a single-processor or multi-processor system of any of a wide array of possible architectures, including field programmable gate array (FPGA), central processing unit (CPU), application specific integrated circuits (ASIC), digital signal processor (DSP) or graphics processing unit (GPU) hardware arranged homogenously or heterogeneously. The memory 220 may be but is not limited to a random access memory (RAM), read only memory (ROM), or other electronic, optical, magnetic or any other computer readable medium.

The computing device 300 may be desktop computer, a laptop computer, or a mobile computing device that is typically carried by a person, such as, for example a phone, a smart phone, a PDA, a smart watch, a tablet, a laptop, or any other mobile computing device known to one of skill in the art.

The computing device 300 includes a controller 310 configured to control operations of the computing device 300. The controller 310 may be an electronic controller including a processor 330 and an associated memory 320 comprising computer-executable instructions (i.e., computer program product) that, when executed by the processor 330, cause the processor 330 to perform various operations. The processor 330 may be, but is not limited to, a single-processor or multi-processor system of any of a wide array of possible architectures, including field programmable gate array (FPGA), central processing unit (CPU), application specific integrated circuits (ASIC), digital signal processor (DSP) or graphics processing unit (GPU) hardware arranged homogenously or heterogeneously. The memory 320 may be but is not limited to a random access memory (RAM), read only memory (ROM), or other electronic, optical, magnetic or any other computer readable medium.

The computing device 300 includes a communication device 340 configured to communicate with the internet 500 through one or more wireless signals 160. The one or more wireless signals 160 may include Wi-Fi, Bluetooth, Zigbee, Sub-GHz RF Channel or any other wireless signal known to one of skill in the art. Alternatively, the computing device 300 may be connected to the internet 500 through a hardwired connection. The computing device 300 is configured to communicate with the system builder device 200 through the internet 500. Communication from the computing device 300 may have to pass through the internet 500 to the system builder device 200. Likewise, communication from the system builder device 200 may have to pass through the internet 500 to computing device 300.

The computing device 300 may include a display device 380, such as for example a computer display, an LCD display, an LED display, an OLED display, a touchscreen of a smart phone, tablet, or any other similar display device known to one of the skill in the art. The user 101 operating the computing device 300 is able to view the fire detection system design application 350 through the display device 380.

The computing device 300 includes an input device 370 configured to receive a manual input from a user 101 (e.g., human being) of computing device 300. The input device 370 may be a keyboard, a touch screen, a joystick, a knob, a touchpad, one or more physical buttons, a microphone configured to receive a voice command, a camera or sensor configured to receive a gesture command, an inertial measurement unit configured to detect a shake of the computing device 300, or any similar input device known to one of skill in the art. The user 101 operating the computing device 300 is able to enter feedback into the fire detection system design application 350 through the input device 370. The input device 370 allows the user 101 operating the computing device 300 to enter feedback into the fire detection system design application 350 via a manual input to input device 370. For example, the user 101 may respond to a prompt on the display device 380 by entering a manual input via the input device 370. In one example, the manual input may be a touch on the touchscreen. In an embodiment, the display device 380 and the input device 370 may be combined into a single device, such as, for example, a touchscreen.

The computing device 300 device may also include a feedback device 360. The feedback device 360 may activate in response to a manual input via the input device 370. The feedback device 360 may be a haptic feedback vibration device and/or a speaker emitting a sound. The feedback device 360 may activate to confirm that the manual input entered via the input device 370 was received via the fire detection system design application 350. For example, the feedback device 360 device may activate by emitting an audible sound or vibrate the computing device 300 to confirm that the manual input entered via the input device 370 was received via the fire detection system design application 350.

FIG. 1 also shows a schematic illustration of a map 60 of a fire detection system 20, according to an embodiment of the present invention. The fire detection system 20 is an example and the embodiments disclosed herein may be applied to other fire detection systems not illustrated herein. The fire detection system 20 comprises one or more fire detection devices 30, one or more fire detector loop wires 40, one or more alert loop wires 42, one or more alert devices 50, and one or more fire panels 54. The one or more fire detection devices 30, one or more fire detector loop wires 40, one or more alert loop wires 42, one or more alert devices 50, and one or more fire panels 54 may be located throughout various rooms 64 of a building 62. The map 60 of a single floor 61 of a building 62 is shown in FIG. 1. It is understood that while the building 62 only shows a particular number of fire detection devices 30, fire detector loop wires 40, alert loop wires 42, alert devices 50, and fire panels 54, the fire detection system 20 may include any number of fire detection devices 30, fire detector loop wires 40, alert loop wires 42, alert devices 50, and fire panels 54.

The fire detection device 30 may be a smoke detector, a CO₂ detector, a CO detector, a heat sensor, or any other fire detector known to one of skill in the art. The alert device 50 may be an alarm that makes an audible sound and/or a visual alert. The alert device 50 may include a bell, a siren, a speaker, a strobe light, or any combination thereof. For example, certain strobes may be utilized if the occupants 112c indicate that certain people will be in located in the building that have adverse effects to different some strobes but not others. The alert device 50 may additionally include any other attention-grabbing device known to one of skill in the art.

The fire detector loop wires 40 connect the one or more fire detection devices 30 with the fire panel 54 in a fire detection loop 32. The fire detection system design application 350 is configured to determine a length of the fire detection loop 32 and a length of the one or more detector loop wires 40 within the fire detection loop 32. This may be done by determining a distance between each fire detection device 30 and then a distance to the fire panel 54 from one or more fire detection devices 30 that are located nearest to the fire panel 54. The fire detection loop 32 may organize the fire detection device 30 in series. The fire detector loop wires 40 may be hardline wires. Alternatively, the one or more fire detection devices 30 and the fire panel 54 within the fire detection loop 32 may be wirelessly connected and the fire detector loop wires 40 may not be present.

The alert loop wires 42 connect the one or more alert devices 50 with the fire panel 54 in an alert loop 52. The alert loop 52 may organize the alert devices 50 in series. The fire detection system design application 350 is configured to determine a length of the alert loop 52 and a length of the one or more alert wires 42 within the alert loop 52. This may be done by determining a distance between each alert device 50 and then a distance to the fire panel 54 from the one or more alert devices 50 that are located nearest to the fire panel 54. The alert loop wires 42 may be hardline wires. Alternatively, the one or more alert devices 50 and the fire panel 54 within the alert loop 52 may be wirelessly connected and the alert loop wires 42 may not be present.

As discussed below, the system 100 is configured to determine placement of the fire detection devices 30 of a fire detection system 20 within a room 64 based on the inputs 110. For example, the system 100 determines whether the fire detection device 30 should be placed on a ceiling or wall of the room 64, where on the ceiling or wall of the room 64 the fire detection devices 30 should be placed. Certain types of fire detection devices 30 may be required to be placed on a ceiling, wall, or an air duct. This information regarding specific placement of different fire detection devices 30 may be found in the fire detection device database 150a.

The system 100 is also configured to determine what type of fire detection devices 30 should be used based on the inputs 110, building requirements 114, and/or data in a fire detection device database 150a. For example, a particular type of fire detection device 30 may be better equipped to detect a smoke from burning certain articles 112e or hazards 112f located in the room 64. This information regarding specific detection capability of different fire detection devices 30 may be found in the fire detection device database 150a.

The system 100 is configured to determine placement of the alert device 50 of a fire detection system 20 within a room 64 based on the inputs 110, building requirements 114, and/or data in an alert device database 150b. For example, the system 100 determines whether the alert device 50 should be placed on a ceiling or wall of the room 64, where on the ceiling or wall of the room 64 the alert device 50 should be placed. The system 100 is also configured to determine what type of alert device 50 should be used based on the inputs 110. Certain types of alert devices 50 may be required to be placed on a ceiling, wall, or an air duct. This information regarding specific placement of different alert devices 50 may be found in the alert device database 150b.

The system 100 is configured to determine connections between the fire detection devices 30 using the fire detector loop wires 40 and a connection between the fire panel 54 and the fire detection devices 30 using the fire detector loop wires 40.

The system 100 is configured to determine connections between the alert device 50 using the alert loop wires 42 and a connection between the fire panel 54 and the alert devices 50 using the alert loop wires 42.

The system 100 is configured to determine a location of the fire panel 54. The location of the fire panel 54 may be iterated multiple times in order to reduce a total length of the fire detector loop wires 40 and a total length of the alert loop wires 42. Alternatively, multiple different location options for the fire panel 54 may be provided to the user 101 to select from.

The system 100 is then configured to generate a map 60 as an output illustrating the location of each of the one or more fire detection devices 30, the one or more alert devices 50, the fire panel 54, the fire detector loop wires 40, and the alert loop wires 42. The map 60 may be generated by the fire detection system design application 350 to be displayed on the computing device 300 or printed out via a computer printer.

The system 100 comprises a plurality of inputs 110 that are entered into a fire detection system design application 350 configured to determine outputs 140 based on at least the inputs 110. The inputs 110 may be entered manually, such as, for example, the user 101 entering in the inputs 110 through the computing device 300. The inputs 110 may also be entered automatically, such as, for example a user 101 scanning a floor plan 112a, capturing images of a floor plan 112a with a camera, or emailing in the inputs 110.

The inputs 110 may include but are not limited to building information 112 and building requirements 114, as shown in FIG. 1. Building information 112 may include but is not limited to floor plans 112a of the building 62 where the fire detection system 20 is to be located, an address 112b of the building 62 where the fire detection system 20 is to be located, a number of occupants 112c of the building 62 where the fire detection system 20 is to be located, a typical building usage 112d of the building 62 where the fire detection system 20 is to be located, types of articles 112e within the building 62 where the fire detection system 20 is to be located, types of hazards 112f within the building 62 where the fire detection system 20 is to be located, and evacuation points 112g within the building 62 where the fire detection system 20 is to be located. It is understood that the input 110 are examples and there may be additional inputs 110 utilized in the systems 100, thus the embodiments of the present invention are not limited to the inputs 110 listed.

The floor plans 112a of the building 62 where the fire detection system 20 is to be located may include details about the floors 61 of the building 62, including, but not limited to, a number of floors 61 within the building 62, the layout of each floor 61 within the building 62, the number of rooms 64 on each floor 61 within the building 62, the height of each room 64, the organization/connectivity of each room 64 on each floor 61 within the building 62, the number of doors 80 within each room 64, the location of the doors 80 in each room 64, the number of windows 90 within each room 64, the location of the windows 90 within each room 64, the number of heating and ventilation vents within each room 64, the location of heating and ventilation vents within each room 64, the number of electrical outlets within each room 64, and the location of electrical outlets within each room 64. The address 112b of the building 62 where the fire detection system 20 is to be located may include, but is not limited to, a street address of the building 62, the geolocation of the building 62, the climate zone where the building 62 is located, and objects surrounding the building 62 (e.g., water, trees, mountains).

The number and type of occupants 112c of the building 62 where the fire detection system 20 is to be located may include, but is not limited to a number of occupants 112c currently in the building 62 and details about the type of occupants 112c (e.g., child, adult, elderly). Further the number of occupants 112c may be updated in real-time of may be a predication. The type of occupants 112c may indicate if they require any specific accommodations from the fire detection system 20. For example, certain people may require certain strobes to be used for the alert device 50 based on a vision impairment. The typical building usage 112d of the building 62 where the fire detection system 20 is to be located may include what the building 62 is being used for such as, for example, residential, lab space, manufacturing, machining, processing, office space, sports, schooling, etc.

The types of articles 112e within the building 62 where the fire detection system 20 is to be located may include detail regarding objects within the building 62 and the known flammability of each object such as, for example, if the building 62 used to store furniture or paper, which is flammable. The articles 112e may include but are not limited to furniture, tables, chairs, rugs, flooring, drapes, cable trays, and/or beds. The articles 112e in the building 62 may help determine what fire detection device 30 to utilized. For example, if a room 64 has a chair and table then a multi-detector may be suggested by the fire detection system design application 350. In another example, if a room 64 has a cable tray then a linear heat detector may be suggested by the fire detection system design application 350. The size of the room 64 may also help determine what type of fire detection device 30 is utilized. In one example, if a room 64 has a high ceiling, a beam detector may be suggested by the fire detection system design application 350.

The types of hazards 112f within the building 62 where the fire detection system 20 is to be located may include a detailed list of hazards 112f within the building 62 and where the hazards 112f are located. For example, the types of hazards 112f may state that an accelerant (e.g., gasoline) is being stored in a room 64 on the second floor 61. In another example, types of hazards 112f may include that a room 64 is mainly used as office where the main components are electronics (e.g., electronics that are possible source of fire) and stationary paper (e.g., accelerants). The types of hazards 112f in the building 62 may help determine what fire detection device 30 to utilized. In an example, if a room 64 has a highly flammable liquid stored then a flame detector may be suggested by the fire detection system design application 350.

The types of evacuation points 112g within the building 62 where the fire detection system 20 is to be located may include a detailed list of evacuations points 112g within the building 62 where an individual may exit the building 62. For example, the types of evacuation points 112g may be windows 90 and doors 80.

Building requirements 114 may include but are not limited to building system requirements 114a of the building 62 where the fire detection system 20 is to be located and a desired level of certification 114b for the building 62 where the fire detection system 20 is to be located. The building system requirements 114a may include but are not limited to the type of fire detection system required and/or desired for the building 62. The desired level of certification 114b may include laws, statutes, regulations, city certification requirements (e.g., local ordinances), state certification requirements (e.g., state laws and regulations), federal certification requirements (e.g., federal laws and regulations), association certification requirements, industry standard certification requirements, and/or trade association certification requirements (e.g., National Fire Protection Association). The building requirements 114 may also include a required number of fire detection devices 30 per room 64, a required distance between each of the fire detection devices 30, a required number of alert devices 50, and a required distance between each of the alert devices 50.

The required distance between each of the fire detection device 30 may also be stored in data located in the fire detection device database 150a because it may be specific to the specific type of fire detection device 30 being used. The required distance between each of the alert devices 50 may also be stored in data located in the alert device database 150b because it may be specific to the specific type of alert device 50 being used.

The inputs 110 are provided to the fire detection system design application 350 to be analyzed with device details in data located in a fire detection system database 150.

The fire detection device database 150a may include data or information such as the types of fire detection devices 30 that may be utilized, performance characteristics for different types of fire detection devices 30, and installation requirements of different type of fire detection devices 30. The installation requirements may include specifications/datasheets for installation constraints as it can be preferred locations for placement, forbidden places, and/or recommended distances from possible fire sources or sources of false detection. For example, a smoke detectors may not be installed in bathrooms as it can trigger false alarms due the vapor, smoke detectors may be installed in a kitchen no close than 3 meters from the fire source (cook/oven) and not further away than 5 meters to avoid late detection, nor the device should be placed closer than 30 centimeters to the ceiling, or preferred placement should be closer to ceiling than to the floor. In another example, in the case of ceiling placement, a device should not be placed closer than X cm to the wall or any blockage object. Other information stored in the fire detection device database 150a may include if the device is battery powered or if the device requires an outlet/what kind of outlet/plug.

The alert device database 150b may include information such as the types of alert devices 50 that may be utilized, performance characteristics for different types of alert device 50, and installation requirements for different types of alert devices 50. The performance characteristics of alert device 50 may include the loudness, brightness, patterns, and/or configurations of each alert device 50.

The fire panel database 150c may include information such as the types of fire panels 54, installation requirements for different types of the fire panels 54, the performance characteristics of each fire panel 54, the compatibility of each fire panel 54 with different types of fire detection devices 30, and the compatibility of each fire panel 54 with different types of alert device 50. The fire panel 54 may be a standalone fire panel or may be networked with one or more other fire panels.

The fire detection system design application 350 is configured to analyze the inputs 110 and data from the fire detection device database 150a to determine a fire detection device placement scheme 140a that includes a number (i.e., quantity), a location, and/or a type of each of the fire detection devices 30 within the building 62. The fire detection system design application 350 is configured to analyze the inputs 110 to determine the fire detector loop wires 40 connecting the fire detection devices 30 to each other and to the fire panel 54. This analysis may be done autonomously by the system 100 or semi-autonomously by the system 100 with the assistance of a user 101.

The fire detection system design application 350 is also configured to analyze the inputs 110 and data from the alert device database 150b to determine an alert device placement scheme 140b that includes a number (i.e., quantity), a location, and/or a type of alert devices 50. The fire detection system design application 350 is configured to analyze the inputs 110 to determine the alert loop wires 42 connecting the alert devices 50 to each other and to the fire panel 54. This analysis may be done autonomously by the system 100 or semi-autonomously by the system 100 with the assistance of a user 101.

The fire detection system design application 350 is also configured to analyze the placement of each fire detection device 30, each alert device 50, and data from the fire panel database 150c to determine an autoconfiguration 140c of the fire panel 54 to associate particular alert devices 50 with particular fire detection device 30. Advantageously, this ensures that when a first detection device 30 detects a fire, then the proper alert devices 50 are activated. The association of a particular alert device 50 with a particular fire detection device 30 may be based on the relative location to each other. For example, all alert devices 50 may be associated with all fire detection devices 30 within the same room 64. In another example, all alert devices 50 may be associated with all fire detection devices 30 on a particular floor 61. In another example, all alert devices 50 that are located within a selected distance of a particular fire detection device 30 may be associated that particular fire detection device 30. The algorithm used for the autoconfigurations will analyze all the inputs 110 from the user 101 and data from the fire detection system device database 150, then provide the advice/options to the end users 101 to configure the fire detection system 20. During this analysis, the algorithm may also consider subject matter expert advice and/or master data that is stored into the internet 500 and/or the system builder 200.

The fire detection system design application 350 may analyze the inputs 110 in an autonomous and/or semi-autonomous manner to determine the fire detection device placement scheme 140a, the alert device placement scheme 140b, and the autoconfiguration 140c of the fire panel 54. For example, in a semi-autonomous manner, the fire detection system design application 350 may generate multiple different fire detection device placement schemes 140a, alert device placement schemes 140b, and autoconfigurations 104c of the fire panel 54 for a user 101 to then review, adjust, and/or make a selection. The fire detection system design application 350 may include artificial intelligence (AI) that learns from the edits made by the user 101 and updates the algorithms behind the fire detection system design application 350 to better generate future determinations of the fire detection device placement scheme 140a, the alert device placement scheme 140b, and the autoconfiguration 140c of the fire panel 54.

In another example, in an autonomous manner, the fire detection system design application 350 may determine a single best option or multiple best options for the fire detection device placement scheme 140a, the alert device placement scheme 140b, and the autoconfiguration 140c of the fire panel 54 to then be presented to the user 101.

The fire detection system 20 may then run a test and activate certain fire detection devices 30 to confirm the proper alert devices 50 activate in response to the fire detection devices 30 that were activated based on the autoconfiguration 140c.

The fire detection system design application 350 may organize the fire detection device placement scheme 140a, the alert device placement scheme 140b, and the autoconfiguration 140c of the fire panel 54 into outputs 140. The outputs 140 may also include the fire detection device placement scheme 140a, the alert device placement scheme 140b, and the autoconfiguration 140c. The outputs 140 may be in the form of a list, a chart, a map 60, or a bill of materials.

The system 100 may also include or be in communication with a fire detection system device databases 150, as aforementioned. The fire detection system device database 150 may be included with the fire detection system design application 350 or accessible to the fire detection system design application 350 through the internet 500. The fire detection system device database 150 may be one or more separate databases stored in one or more locations. The fire detection system device database 150 may include data, details, and specifications of devices that may be utilized in a fire detection system 20. The fire detection system device databases 150 may be a single central repository that is updated either periodically or in real-time. The fire detection system device databases 150 may also link to outside databases in real-time, such as, for example online supplier databases of components for a fire detection system 20. The fire detection system device databases 150 may include a fire detection device database 150a, an alert device database 150b, and a fire panel device database 150c.

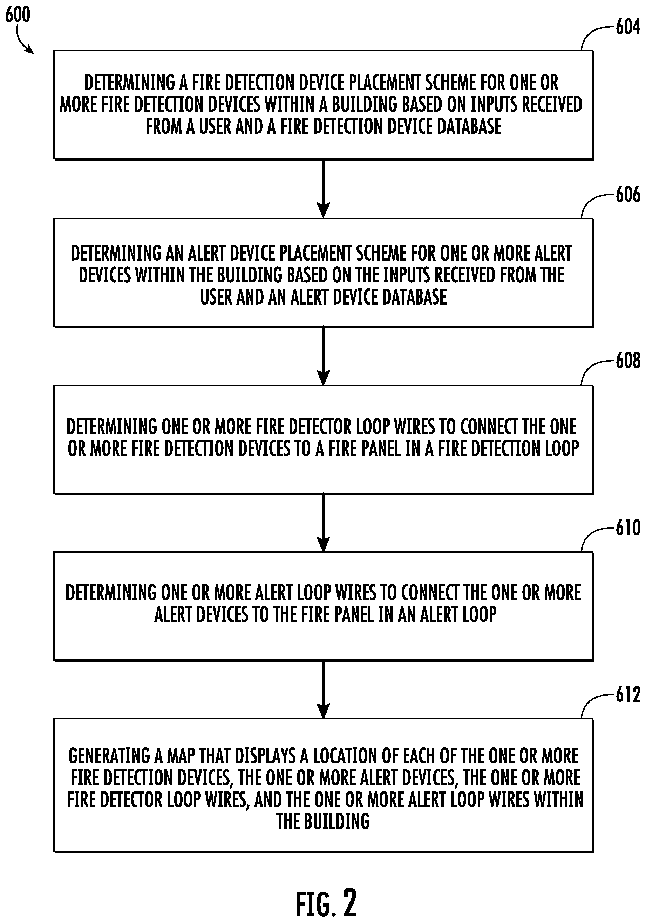

Referring now to FIG. 2, with continued reference to FIG. 1, a flow diagram illustrating a computer implemented method 600 of designing a fire detection system 20 is illustrated in accordance with an embodiment of the present invention. In embodiment, the computer implemented method 600 is performed by the fire detection system design application 350.

At block 604, a fire detection device placement scheme 140a for one or more fire detection devices 30 within a building 62 is determined based on inputs 110 received from a user 101 and a fire detection device database 150a. The fire detection device placement scheme 140a may include a number of the one or more fire detection devices 30. The fire detection device placement scheme 140a may also include a type of the one or more fire detection devices 30.

At block 606, an alert device placement scheme 140b for the one or more alert devices 50 within the building 62 is determined based on the inputs 110 received from the user 101 and an alert device database 150b. The alert device placement scheme 140b may include a number of the one or more alert devices 50. The alert device placement scheme 140b may also include a type of the one or more alert devices 50.

At block 608, one or more fire detector loop wires 40 are determined to connect the one or more fire detection devices 30 to a fire panel 54 in a fire detection loop 32.

At block 610, one or more alert loop wires 42 are determined to connect the one or more alert devices 50 to the fire panel 54 in an alert loop 52.

At block 612, a map 60 is generated that displays a location of each of the one or more fire detection devices 30, the one or more alert devices 50, the one or more fire detector loop wires 40, and the one or more alert loop wires 42 within the building 62.

The computer implemented method 600 may further include that the map 60 is displayed on a computing device 300. The computer implemented method 600 includes that an autoconfiguration 140c of the fire panel 54 to associate a specific alert device 50 of the one or more alert devices 50 with a specific fire detection device 30 of the one or more fire detection devices 30 is determined.

The autoconfiguration 140c may then be tested by activating certain fire detection devices 30 and seeing if the proper alert devices 50 respond. The computer implemented method 600 may further include activating the specific fire detection device 30, detecting whether the specific alert device 50 activates in response to the specific fire detection device 30 being activated, and determining whether the autoconfiguration 140c was successful based on detecting whether the specific alert device 50 activates in response to the specific fire detection device 30 being activated.

The computer implemented method 600 may yet further include that a length of the fire detection loop 32 and a length of the one or more detector loop wires 40 within the fire detection loop 32 are determined. The computer implemented method 600 may also include a length of the alert loop 52 and a length of the one or more alert wires 42 within the alert loop 52 are determined.

While the above description has described the flow process of FIG. 2 in a particular order, it should be appreciated that unless otherwise specifically required in the attached claims that the ordering of the steps may be varied.

As described above, embodiments can be in the form of processor-implemented processes and devices for practicing those processes, such as processor. Embodiments can also be in the form of computer program code (e.g., computer program product) containing instructions embodied in tangible media (e.g., non-transitory computer readable medium), such as floppy diskettes, CD ROMs, hard drives, or any other non-transitory computer readable medium, wherein, when the computer program code is loaded into and executed by a computer, the computer becomes a device for practicing the embodiments. Embodiments can also be in the form of computer program code, for example, whether stored in a storage medium, loaded into and/or executed by a computer, or transmitted over some transmission medium, such as over electrical wiring or cabling, through fiber optics, or via electromagnetic radiation, wherein, when the computer program code is loaded into and executed by a computer, the computer becomes a device for practicing the exemplary embodiments. When implemented on a general-purpose microprocessor, the computer program code segments configure the microprocessor to create specific logic circuits.

The term "about" is intended to include the degree of error associated with measurement of the particular quantity based upon the equipment available at the time of filing the application. For example, "about" can include a range of ± 8% or 5%, or 2% of a given value.

The terminology used herein is for the purpose of describing particular embodiments only and is not intended to be limiting of the present invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present invention has been described with reference to an exemplary embodiment or embodiments, it will be understood by those skilled in the art that various changes may be made without departing from the scope of the invention as defined by the appended claims. In addition, many modifications may be made to adapt a particular situation or material to the teachings of the present invention without departing from the scope of the claims. Therefore, it is intended that the present invention not be limited to the particular embodiment disclosed as a best mode contemplated for carrying out this present invention, but that the present invention will include all embodiments falling within the scope of the claims.

## Claims

1. A computer implemented method (600) of designing a fire detection system (20), the computer implemented method comprising:
determining (604) a fire detection device placement scheme (140a) for one or more fire detection devices (30) within a building (62) based on inputs (110) received from a user (101) and a fire detection device database (150a);
determining (606) an alert device placement scheme (140b) for one or more alert devices (50) within the building (62) based on the inputs (110) received from the user (101) and an alert device database (150b);
determining (608) one or more fire detector loop wires (40) to connect the one or more fire detection devices (30) to a fire panel (54) in a fire detection loop (32);
determining (610) one or more alert loop wires (42) to connect the one or more alert devices (50) to the fire panel (54) in an alert loop (52); and
generating (612) a map (60) that displays a location of each of the one or more fire detection devices (30), the one or more alert devices (50), the one or more fire detector loop wires (40), and the one or more alert loop wires (42) within the building (62),
**characterised in that** the method comprises:
determining an autoconfiguration (140c) of the fire panel (54) to associate a specific alert device (50) of the one or more alert devices (50) with a specific fire detection device (30) of the one or more fire detection devices (30).

2. The computer implemented method (600) of claim 1, further comprising:
displaying the map (60) on a computing device (300).

3. The computer implemented method (600) of claim 1 or 2, further comprising:
activating the specific fire detection device (30);
detecting whether the specific alert device (50) activates in response to the specific fire detection device (30) being activated; and
determine whether the autoconfiguration (140c) was successful based on detecting whether the specific alert device (50) activates in response to the specific fire detection device (30) being activated.

4. The computer implemented method (600) of any preceding claim, wherein:
the fire detection device placement scheme (140a) includes a number of the one or more fire detection devices (30); and/or
the alert device placement scheme (140b) includes a number of the one or more alert devices (50).

5. The computer implemented method (600) of any preceding claim, wherein:
the fire detection device placement scheme (140a) includes a type of the one or more fire detection devices (30); and/or
the alert device placement scheme (140b) includes a type of the one or more alert devices (50).

6. The computer implemented method (600) of any preceding claim, further comprising:
determining a length of the fire detection loop (32) and a length of the one or more detector loop wires within the fire detection loop (32).

7. The computer implemented method (600) of any preceding claim, further comprising:
determining a length of the alert loop (52) and a length of the one or more alert wires within the alert loop (52).

8. A system (100) for designing a fire detection system (20), the system comprising:
a processor (230; 330); and
a memory (220; 320) comprising computer-executable instructions that, when executed by the processor, cause the processor to perform operations, the operations comprising:
determining (604) a fire detection device placement scheme (140a) for one or more fire detection devices (30) within a building (62) based on inputs (110) received from a user (101) and a fire detection device database (150a);
determining (606) an alert device placement scheme (140b) for one or more alert devices (50) within the building (62) based on the inputs (110) received from the user (101) and an alert device database (150b);
determining (608) one or more fire detector loop wires (40) to connect the one or more fire detection devices (30) to a fire panel (54) in a fire detection loop (32);
determining (610) one or more alert loop wires (42) to connect the one or more alert devices (50) to the fire panel in an alert loop (52); and
generating (612) a map (60) that displays a location of each of the one or more fire detection devices (30), the one or more alert devices (50), the one or more fire detector loop wires (40), and the one or more alert loop wires (42) within the building (62),
**characterised in that** the operations comprise:
determining an autoconfiguration (140c) of the fire panel (54) to associate a specific alert device (50) of the one or more alert devices (50) with a specific fire detection device (30) of the one or more fire detection devices (30).

9. The system (100) of claim 8, wherein the operations further comprise:
displaying the map (60) on a computing device (300).

10. The system (100) of claim 9, wherein the operations further comprise:
activating the specific fire detection device (30);
detecting whether the specific alert device (50) activates in response to the specific fire detection device (30) being activated; and
determine whether the autoconfiguration (140c) was successful based on detecting whether the specific alert device (50) activates in response to the specific fire detection device (30) being activated.

11. The system (100) of any of claims 8 to 10, wherein:
the fire detection device placement scheme (140a) includes a number of the one or more fire detection devices (30).

12. The system (100) of any of claims 8 to 11, wherein:
the alert device placement scheme (140b) includes a number of the one or more alert devices (50).

13. The system (100) of any of claims 8 to 12, wherein:
the fire detection device placement scheme (140a) includes a type of the one or more fire detection devices (30); and/or
the alert device placement scheme (140b) includes a type of the one or more alert devices (50).

14. The system (100) of any of claims 8 to 13, wherein the operations further comprise:
determining a length of the fire detection loop (32) and a length of the one or more detector loop wires (40) within the fire detection loop (32).

15. A computer program product tangibly embodied on a non-transitory computer readable medium, the computer program product including instructions that, when executed by a processor, cause the processor to perform operations comprising:
determining (604) a fire detection device placement scheme (140a) for one or more fire detection devices (30) within a building (62) based on inputs (110) received from a user (101) and a fire detection device database (150a);
determining (606) an alert device placement scheme (140b) for one or more alert devices (50) within the building (62) based on the inputs (110) received from the user (101) and an alert device database (150b);
determining (608) one or more fire detector loop wires (40) to connect the one or more fire detection devices (30) to a fire panel (54) in a fire detection loop (32);
determining (610) one or more alert loop wires (42) to connect the one or more alert devices (50) to the fire panel in an alert loop (52); and
generating (612) a map (60) that displays a location of each of the one or more fire detection devices (30), the one or more alert devices (50), the one or more fire detector loop wires (40), and the one or more alert loop wires (42) within the building (62);
**characterised in that** the operations comprise:
determining an autoconfiguration (140c) of the fire panel (54) to associate a specific alert device (50) of the one or more alert devices (50) with a specific fire detection device (30) of the one or more fire detection devices (30).

## Patentansprüche

1. Computerimplementiertes Verfahren (600) zum Auslegen eines Branderkennungssystems (20), wobei das computerimplementierte Verfahren Folgendes umfasst:
Bestimmen (604) eines Branderkennungsvorrichtungsanordnungsschemas (140a) für eine oder mehrere Branderkennungsvorrichtungen (30) innerhalb eines Gebäudes (62) basierend auf Eingaben (110), die von einem Benutzer (101) und einer Branderkennungsvorrichtungsdatenbank (150a) empfangen werden;
Bestimmen (606) eines Warnvorrichtungsanordnungsschemas (140b) für eine oder mehrere Warnvorrichtungen (50) innerhalb des Gebäudes (62) basierend auf den von dem Benutzer (101) empfangenen Eingaben (110) und einer Warnvorrichtungsdatenbank (150b);
Bestimmen (608) eines oder mehrerer Branderkennungsschleifendrähte (40) zum Verbinden der einen oder mehreren Branderkennungsvorrichtungen (30) mit einem Brandpanel (54) in einer Branderkennungsschleife (32);
Bestimmen (610) eines oder mehrerer Warnschleifendrähte (42) zum Verbinden der einen oder mehreren Warnvorrichtungen (50) mit dem Brandpanel (54) in einer Warnschleife (52); und
Erzeugen (612) einer Karte (60), die einen Standort jeder der einen oder mehreren Branderkennungsvorrichtungen (30), der einen oder mehreren Warnvorrichtungen (50), der einen oder mehreren Branderkennungsschleifendrähte (40) und der einen oder mehreren Warnschleifendrähte (42) innerhalb des Gebäudes (62) anzeigt,
**dadurch gekennzeichnet, dass** das Verfahren Folgendes umfasst:
Bestimmen einer Autokonfiguration (140c) des Brandpanels (54) zum Zuordnen einer spezifischen Warnvorrichtung (50) der einen oder mehreren Warnvorrichtungen (50) zu einer spezifischen Branderkennungsvorrichtung (30) der einen oder mehreren Branderkennungsvorrichtungen (30).

2. Computerimplementiertes Verfahren (600) nach Anspruch 1, ferner umfassend:
Anzeigen der Karte (60) auf einer Rechenvorrichtung (300).

3. Computerimplementiertes Verfahren (600) nach Anspruch 1 oder 2, ferner umfassend:
Aktivieren der spezifischen Branderkennungsvorrichtung (30);
Erkennen, ob die spezifische Warnvorrichtung (50) als Reaktion auf die Aktivierung der spezifischen Branderkennungsvorrichtung (30) aktiviert wird; und
Bestimmen, ob die Autokonfiguration (140c) erfolgreich war, indem überprüft wird, ob die spezifische Warnvorrichtung (50) als Reaktion auf die Aktivierung der spezifischen Branderkennungsvorrichtung (30) aktiviert wird.

4. Computerimplementiertes Verfahren (600) nach einem der vorhergehenden Ansprüche, wobei:
das Branderkennungsvorrichtungsanordnungsschema (140a) eine Angabe über die Anzahl der einen oder mehreren Branderkennungsvorrichtungen (30) einschließt; und/oder
das Warnvorrichtungsanordnungsschema (140b) eine Angabe über die Anzahl der einen oder mehreren Warnvorrichtungen (50) einschließt.

5. Computerimplementiertes Verfahren (600) nach einem der vorhergehenden Ansprüche, wobei:
das Branderkennungsvorrichtungsanordnungsschema (140a) eine Angabe über den Typ der einen oder mehreren Branderkennungsvorrichtungen (30) einschließt; und/oder
das Warnvorrichtungsanordnungsschema (140b) eine Angabe über den Typ der einen oder mehreren Warnvorrichtungen (50) einschließt.

6. Computerimplementiertes Verfahren (600) nach einem der vorhergehenden Ansprüche, ferner umfassend:
Bestimmen einer Länge der Branderkennungsschleife (32) sowie der Länge der einen oder mehreren Erkennungsschleifendrähte innerhalb der Branderkennungsschleife (32).

7. Computerimplementiertes Verfahren (600) nach einem der vorhergehenden Ansprüche, ferner umfassend:
Bestimmen einer Länge der Warnschleife (52) sowie der Länge der einen oder mehreren Warndrähte innerhalb der Warnschleife (52).

8. System (100) zur Planung eines Branderkennungssystems (20), wobei das System Folgendes umfasst:
einen Prozessor (230; 330); und
einen Speicher (220; 320), der computerausführbare Anweisungen umfasst, die, wenn sie von dem Prozessor ausgeführt werden, den Prozessor dazu bringen, Operationen auszuführen, wobei die Operationen Folgendes umfassen:
Bestimmen (604) eines Branderkennungsvorrichtungsanordnungsschemas (140a) für eine oder mehrere Branderkennungsvorrichtungen (30) innerhalb eines Gebäudes (62) basierend auf Eingaben (110), die von einem Benutzer (101) und einer Branderkennungsvorrichtungsdatenbank (150a) empfangen werden;
Bestimmen (606) eines Warnvorrichtungsanordnungsschemas (140b) für eine oder mehrere Warnvorrichtungen (50) innerhalb des Gebäudes (62) basierend auf den von dem Benutzer (101) empfangenen Eingaben (110) und einer Warnvorrichtungsdatenbank (150b);
Bestimmen (608) eines oder mehrerer Branderkennungsschleifendrähte (40) zum Verbinden der einen oder mehreren Branderkennungsvorrichtungen (30) mit einem Brandpanel (54) in einer Branderkennungsschleife (32);
Bestimmen (610) eines oder mehrerer Warnschleifendrähte (42) zum Verbinden der einen oder mehreren Warnvorrichtungen (50) mit dem Brandpanel in einer Warnschleife (52); und
Erzeugen (612) einer Karte (60), die einen Standort jeder der einen oder mehreren Branderkennungsvorrichtungen (30), der einen oder mehreren Warnvorrichtungen (50), der einen oder mehreren Branderkennungsschleifendrähte (40) und der einen oder mehreren Warnschleifendrähte (42) innerhalb des Gebäudes (62) anzeigt,
**dadurch gekennzeichnet, dass** die Operationen Folgendes umfassen:
Bestimmen einer Autokonfiguration (140c) des Brandpanels (54) zum Zuordnen einer spezifischen Warnvorrichtung (50) der einen oder mehreren Warnvorrichtungen (50) zu einer spezifischen Branderkennungsvorrichtung (30) der einen oder mehreren Branderkennungsvorrichtungen (30).

9. System (100) nach Anspruch 8, wobei die Operationen ferner Folgendes umfassen: Anzeigen der Karte (60) auf einer Rechenvorrichtung (300).

10. System (100) nach Anspruch 9, wobei die Operationen ferner Folgendes umfassen:
Aktivieren der spezifischen Branderkennungsvorrichtung (30);
Erkennen, ob die spezifische Warnvorrichtung (50) als Reaktion auf die Aktivierung der spezifischen Branderkennungsvorrichtung (30) aktiviert wird; und
Bestimmen, ob die Autokonfiguration (140c) erfolgreich war, indem überprüft wird, ob die spezifische Warnvorrichtung (50) als Reaktion auf die Aktivierung der spezifischen Branderkennungsvorrichtung (30) aktiviert wird.

11. System (100) nach einem der Ansprüche 8 bis 10, wobei:
das Branderkennungsvorrichtungsanordnungsschema (140a) eine Angabe über die Anzahl der einen oder mehreren Branderkennungsvorrichtungen (30) einschließt.

12. System (100) nach einem der Ansprüche 8 bis 11, wobei:
das Warnvorrichtungsanordnungsschema (140b) eine Angabe über die Anzahl der einen oder mehreren Warnvorrichtungen (50) einschließt.

13. System (100) nach einem der Ansprüche 8 bis 12, wobei:
das Branderkennungsvorrichtungsanordnungsschema (140a) eine Angabe über den Typ der einen oder mehreren Branderkennungsvorrichtungen (30) einschließt; und/oder
das Warnvorrichtungsanordnungsschema (140b) eine Angabe über den Typ der einen oder mehreren Warnvorrichtungen (50) einschließt.

14. System (100) nach einem der Ansprüche 8 bis 13, wobei die Operationen ferner Folgendes umfassen:
Bestimmen der Länge der Branderkennungsschleife (32) und der Länge der einen oder mehreren Erkennungsschleifendrähte (40) innerhalb der Branderkennungsschleife (32).

15. Computerprogrammprodukt, das auf einem nicht flüchtigen, computerlesbaren Medium greifbar verkörpert ist, wobei das Computerprogrammprodukt Anweisungen einschließt, die, wenn sie von einem Prozessor ausgeführt werden, den Prozessor veranlassen, Operationen auszuführen, die Folgendes umfassen:
Bestimmen (604) eines Branderkennungsvorrichtungsanordnungsschemas (140a) für eine oder mehrere Branderkennungsvorrichtungen (30) innerhalb eines Gebäudes (62) basierend auf Eingaben (110), die von einem Benutzer (101) und einer Branderkennungsvorrichtungsdatenbank (150a) empfangen werden;
Bestimmen (606) eines Warnvorrichtungsanordnungsschemas (140b) für eine oder mehrere Warnvorrichtungen (50) innerhalb des Gebäudes (62) basierend auf den von dem Benutzer (101) empfangenen Eingaben (110) und einer Warnvorrichtungsdatenbank (150b);
Bestimmen (608) eines oder mehrerer Branderkennungsschleifendrähte (40) zum Verbinden der einen oder mehreren Branderkennungsvorrichtungen (30) mit einem Brandpanel (54) in einer Branderkennungsschleife (32);
Bestimmen (610) eines oder mehrerer Warnschleifendrähte (42) zum Verbinden der einen oder mehreren Warnvorrichtungen (50) mit dem Brandpanel in einer Warnschleife (52); und
Erzeugen (612) einer Karte (60), die einen Standort jeder der einen oder mehreren Branderkennungsvorrichtungen (30), der einen oder mehreren Warnvorrichtungen (50), der einen oder mehreren Branderkennungsschleifendrähte (40) und der einen oder mehreren Warnschleifendrähte (42) innerhalb des Gebäudes (62) anzeigt;
**dadurch gekennzeichnet, dass** die Operationen Folgendes umfassen:
Bestimmen einer Autokonfiguration (140c) des Brandpanels (54) zum Zuordnen einer spezifischen Warnvorrichtung (50) der einen oder mehreren Warnvorrichtungen (50) zu einer spezifischen Branderkennungsvorrichtung (30) der einen oder mehreren Branderkennungsvorrichtungen (30).

## Revendications

1. Procédé (600) mis en œuvre par ordinateur pour la conception d'un système (20) de détection d'incendie, le procédé mis en œuvre par ordinateur comprenant :
la détermination (604) d'un schéma (140a) de positionnement de dispositifs de détection d'incendie pour un ou plusieurs dispositifs (30) de détection d'incendie dans un bâtiment (62) sur la base d'entrées (110) reçues d'un utilisateur (101) et d'une base de données (150a) de dispositifs de détection d'incendie ;
la détermination (606) d'un schéma (140b) de positionnement de dispositifs d'alerte pour un ou plusieurs dispositifs (50) d'alerte dans le bâtiment (62) sur la base des entrées (110) reçues de l'utilisateur (101) et d'une base de données (150b) de dispositifs d'alerte ;
la détermination (608) d'un ou plusieurs fils (40) de boucle de détecteur d'incendie pour connecter les un ou plusieurs dispositifs (30) de détection d'incendie à un panneau (54) d'incendie dans une boucle (32) de détection d'incendie ;
la détermination (610) d'un ou plusieurs fils (42) de boucle d'alerte pour connecter les un ou plusieurs dispositifs (50) d'alerte au panneau (54) d'incendie dans une boucle (52) d'alerte ; et
la génération (612) d'une carte (60) qui affiche un emplacement de chacun des un ou plusieurs dispositifs (30) de détection d'incendie, des un ou plusieurs dispositifs (50) d'alerte, des un ou plusieurs fils (40) de boucle de détecteur d'incendie et des un ou plusieurs fils (42) de boucle d'alerte dans le bâtiment (62),
**caractérisé en ce que** le procédé comprend :
la détermination d'une autoconfiguration (140c) du panneau (54) d'incendie pour associer un dispositif (50) d'alerte spécifique parmi les un ou plusieurs dispositifs (50) d'alerte à un dispositif (30) de détection d'incendie spécifique parmi les un ou plusieurs dispositifs (30) de détection d'incendie.

2. Procédé (600) mis en œuvre par ordinateur selon la revendication 1, comprenant en outre :
l'affichage de la carte (60) sur un dispositif informatique (300).

3. Procédé (600) mis en œuvre par ordinateur selon la revendication 1 ou la revendication 2, comprenant en outre :
l'activation du dispositif (30) de détection d'incendie spécifique ;
la détection de l'activation ou non du dispositif (50) d'alerte spécifique en réponse à l'activation du dispositif (30) de détection d'incendie spécifique ; et
le fait de déterminer si l'autoconfiguration (140c) a réussi selon la détection de l'activation ou non du dispositif (50) d'alerte spécifique en réponse à l'activation du dispositif (30) de détection d'incendie spécifique.

4. Procédé (600) mis en œuvre par ordinateur selon une quelconque revendication précédente, dans lequel :
le schéma (140a) de positionnement de dispositifs de détection d'incendie inclut une indication d'un nombre des un ou plusieurs dispositifs (30) de détection d'incendie ; et/ou
le schéma (140b) de positionnement de dispositifs d'alerte inclut une indication d'un nombre des un ou plusieurs dispositifs (50) d'alerte.

5. Procédé (600) mis en œuvre par ordinateur selon une quelconque revendication précédente, dans lequel :
le schéma (140a) de positionnement de dispositifs de détection d'incendie inclut une indication d'un type des un ou plusieurs dispositifs (30) de détection d'incendie ; et/ou
le schéma (140b) de positionnement de dispositifs d'alerte inclut une indication d'un type des un ou plusieurs dispositifs (50) d'alerte.

6. Procédé (600) mis en œuvre par ordinateur selon une quelconque revendication précédente, comprenant en outre :
la détermination d'une longueur de la boucle (32) de détection d'incendie et d'une longueur des un ou plusieurs fils de boucle de détecteur dans la boucle (32) de détection d'incendie.

7. Procédé (600) mis en œuvre par ordinateur selon une quelconque revendication précédente, comprenant en outre :
la détermination d'une longueur de la boucle (52) d'alerte et d'une longueur des un ou plusieurs fils d'alerte dans la boucle (52) d'alerte.

8. Système (100) pour la conception d'un système (20) de détection d'incendie, comprenant :
un processeur (230 ; 330) ; et
une mémoire (220 ; 320) comprenant des instructions exécutables par ordinateur qui, lorsqu'elles sont exécutées par le processeur, amènent le processeur à réaliser des opérations, les opérations comprenant :
la détermination (604) d'un schéma (140a) de positionnement de dispositifs de détection d'incendie pour un ou plusieurs dispositifs (30) de détection d'incendie dans un bâtiment (62) sur la base d'entrées (110) reçues d'un utilisateur (101) et d'une base de données (150a) de dispositifs de détection d'incendie ;
la détermination (606) d'un schéma (140b) de positionnement de dispositifs d'alerte pour un ou plusieurs dispositifs (50) d'alerte dans le bâtiment (62) sur la base des entrées (110) reçues de l'utilisateur (101) et d'une base de données (150b) de dispositifs d'alerte ;
la détermination (608) d'un ou plusieurs fils (40) de boucle de détecteur d'incendie pour connecter les un ou plusieurs dispositifs (30) de détection d'incendie à un panneau (54) d'incendie dans une boucle (32) de détection d'incendie ;
la détermination (610) d'un ou plusieurs fils (42) de boucle d'alerte pour connecter les un ou plusieurs dispositifs (50) d'alerte au panneau d'incendie dans une boucle (52) d'alerte ; et
la génération (612) d'une carte (60) qui affiche un emplacement de chacun des un ou plusieurs dispositifs (30) de détection d'incendie, des un ou plusieurs dispositifs (50) d'alerte, des un ou plusieurs fils (40) de boucle de détecteur d'incendie et des un ou plusieurs fils (42) de boucle d'alerte dans le bâtiment (62),
**caractérisé en ce que** les opérations comprennent :
la détermination d'une autoconfiguration (140c) du panneau (54) d'incendie pour associer un dispositif (50) d'alerte spécifique parmi les un ou plusieurs dispositifs (50) d'alerte à un dispositif (30) de détection d'incendie spécifique parmi les un ou plusieurs dispositifs (30) de détection d'incendie.

9. Système (100) selon la revendication 8, dans lequel les opérations comprennent en outre : l'affichage de la carte (60) sur un dispositif informatique (300).

10. Système (100) selon la revendication 9, dans lequel les opérations comprennent en outre :
l'activation du dispositif (30) de détection d'incendie spécifique ;
la détection de l'activation ou non du dispositif (50) d'alerte spécifique en réponse à l'activation du dispositif (30) de détection d'incendie spécifique ; et
le fait de déterminer si l'autoconfiguration (140c) a réussi selon la détection de l'activation ou non du dispositif (50) d'alerte spécifique en réponse à l'activation du dispositif (30) de détection d'incendie spécifique.

11. Système (100) selon l'une quelconque des revendications 8 à 10, dans lequel :
le schéma (140a) de positionnement de dispositifs de détection d'incendie inclut une indication d'un nombre des un ou plusieurs dispositifs (30) de détection d'incendie.

12. Système (100) selon l'une quelconque des revendications 8 à 11, dans lequel :
le schéma (140b) de positionnement de dispositifs d'alerte inclut une indication d'un nombre des un ou plusieurs dispositifs (50) d'alerte.

13. Système (100) selon l'une quelconque des revendications 8 à 12, dans lequel :
le schéma (140a) de positionnement de dispositifs de détection d'incendie inclut une indication d'un type des un ou plusieurs dispositifs (30) de détection d'incendie ; et/ou
le schéma (140b) de positionnement de dispositifs d'alerte inclut une indication d'un type des un ou plusieurs dispositifs (50) d'alerte.

14. Système (100) selon l'une quelconque des revendications 8 à 13, dans lequel les opérations comprennent en outre :
la détermination d'une longueur de la boucle (32) de détection d'incendie et d'une longueur des un ou plusieurs fils (40) de boucle de détecteur dans la boucle (32) de détection d'incendie.

15. Produit programme d'ordinateur incorporé de manière tangible sur un support non transitoire lisible par ordinateur, le produit programme d'ordinateur incluant des instructions qui, lorsqu'elles sont exécutées par un processeur, amènent le processeur à réaliser des opérations comprenant :
la détermination (604) d'un schéma (140a) de positionnement de dispositifs de détection d'incendie pour un ou plusieurs dispositifs (30) de détection d'incendie dans un bâtiment (62) sur la base d'entrées (110) reçues d'un utilisateur (101) et d'une base de données (150a) de dispositifs de détection d'incendie ;
la détermination (606) d'un schéma (140b) de positionnement de dispositifs d'alerte pour un ou plusieurs dispositifs (50) d'alerte dans le bâtiment (62) sur la base des entrées (110) reçues de l'utilisateur (101) et d'une base de données (150b) de dispositifs d'alerte ;
la détermination (608) d'un ou plusieurs fils (40) de boucle de détecteur d'incendie pour connecter les un ou plusieurs dispositifs (30) de détection d'incendie à un panneau (54) d'incendie dans une boucle (32) de détection d'incendie ;
la détermination (610) d'un ou plusieurs fils (42) de boucle d'alerte pour connecter les un ou plusieurs dispositifs (50) d'alerte au panneau d'incendie dans une boucle (52) d'alerte ; et
la génération (612) d'une carte (60) qui affiche un emplacement de chacun des un ou plusieurs dispositifs (30) de détection d'incendie, des un ou plusieurs dispositifs (50) d'alerte, des un ou plusieurs fils (40) de boucle de détecteur d'incendie et des un ou plusieurs fils (42) de boucle d'alerte dans le bâtiment (62) ;
**caractérisé en ce que** les opérations comprennent :
la détermination d'une autoconfiguration (140c) du panneau (54) d'incendie pour associer un dispositif (50) d'alerte spécifique parmi les un ou plusieurs dispositifs (50) d'alerte à un dispositif (30) de détection d'incendie spécifique parmi les un ou plusieurs dispositifs (30) de détection d'incendie.
